# EUROPEAN PATENT SPECIFICATION

(11) **EP 1 789 527 B1**
(45) Date of publication and mention of the grant of the patent: **02.12.2009**
(21) Application number: 05776485.4
(22) Date of filing: 23.06.2005
(51) Int. Cl.: C11D 11/00, G03F 7/42, H05K 3/26, C11D 3/20, C11D 3/30, C11D 7/26, C11D 7/32, C11D 3/43, C11D 7/50

(54) **CLEANING COMPOSITIONS FOR MICROELECTRONICS SUBSTRATES**
REINIGUNGSMITTEL FÜR MIKROELEKTRONIK-SUBSTRATE
COMPOSITIONS DE NETTOYAGE POUR SUBSTRATS MICROÉLECTRONIQUES

(30) Priority: 03.08.2004 US 598318 P
(43) Date of publication of application: 30.05.2007
(73) Proprietor: Mallinckrodt Baker, Inc., Phillipsburg, New Jersey 08865 (US)
(72) Inventor: KANE, Sean, M., Lyndhurst, Ohio 44124 (US)
(74) Representative: Cockerton, Bruce Roger
(86) International application number: PCT/US2005/022598
(87) International publication number: WO 2006/023061

(56) References cited:
- US-A1- 2003 228 990
- US-A1- 2004 067 860
- US-B1- 6 276 372
- US-B1- 6 546 939

## Description

### FIELD OF THE INVENTION

This invention pertains to cleaning and stripping compositions for microelectronic substrates and particularly for cleaning metal-containing residues from aluminum-containing microelectronics components without causing undue aluminum corrosion. The invention also relates to cleaning of vias that punch through metal layers of microelectronics components, such as titanium or titanium nitride layers, while being compatible with underlying aluminum structures, i.e., causing little or no metal corrosion in the microelectronics components. The invention further relates to such cleaning compositions that also are able to clean post-ash residue from other vias and from metal lines as well as cleaning or stripping unashed photoresist from microelectronics substrates. A further aspect of this invention is a process of cleaning or stripping photoresist and residue from aluminum-containing microelectronics components without causing undue aluminum corrosion.

### BACKGROUND TO THE INVENTION

During the manufacture of microelectronic devices photoresists are employed to transfer images to a microelectronics substrate to create the desired circuit layer. Many of the microelectronic devices are metallized with aluminum. Also, the microelectronics substrate may employ metals such as titanium, titanium nitride, tungsten and the like as adhesion promoters and diffusion barriers.

Many alkaline microelectronic stripping and cleaning compositions have been proposed for the removal of cross-linked and hardened photoresists and other residues, such as post etch residues, from such microelectronic substrates. However, one problem with such stripping and cleaning composition is the possibility of metal corrosion occurring as a result of the use of such cleaning compositions. Such corrosion results in whiskers, pitting, notching of metal lines, due at least in part to the reaction of the metals in the device substrates with the alkaline strippers employed. One such alkaline microelectronic stripping and cleaning composition is that disclosed in US patent No. 5,308,745. While the stripping and cleaning compositions of that patent have been commercially employed to strip hardened and cross-linked photoresist from substrates, it has been discovered that attempts to clean microelectronic substrates having aluminum metallization and containing residues of metals from layers such as layers of titanium, titanium nitride, tungsten and the like, with the cleaning composition of this patent has resulted in significant aluminum corrosion or insufficient cleaning of the metal residues. Therefore, there is a limitation on the use of the cleaning compositions of that patent in the cleaning of vias that punch-through underlying layers of titanium, titanium nitride, tungsten and the like.

There is therefore a need for microelectronic stripping and cleaning compositions that can effectively remove such metal residues and do so without any significant aluminum corrosion resulting from the stripping and cleaning composition. There is also a need for stripping and cleaning compositions that, in addition to cleaning these metal residues, will also effectively clean post-ash residues from other vias and from metal lines, as well as cleaning unashed photoresist residue from the substrate.

### BRIEF SUMMARY OF THE INVENTION

In accordance with this invention, there are provided stripping and cleaning compositions for cleaning microelectronics substrates, the composition comprising: at least one organic stripping solvent, at least one nucleophilic alkanolamine, at least one non-nitrogen containing weak acid in an amount sufficient to neutralize from about 3% to about 75%, preferably from about ,19 % to about 75%, by weight of the nucleophilic alkanolamine such that the stripping composition has an aqueous pH of from about 9.6 to about 10.9, said weak acid having a pK value in aqueous solution of 2.0 or greater and an equivalent weight of less than 140, at least one metal-removing compound selected from the group consisting of diethylene glycol and diethylene glycolamine, and water, and methods for cleaning microelectronic substrates with these compositions.

The stripping and cleaning composition of this invention for cleaning microelectronics substrates consists of:
a) at least one organic stripping solvent comprising a solvent selected from the group consisting of 2-pyrrolidinone, 1-methyl-2-pyrrolidinone, 1-ethyl-2-pyrrolidinone, 1-propyl-2-pyrrolidinone, 1-hydroxyethyl-2-pyrrolidinone, 1-hydroxypropyl-2-pyrrolidinone, diethylene glycol monoalkyl ethers of the formula HO-CH₂-O-CH₂-CH₂-O-R where R is an alkyl radical of from 1 to 4 carbon atoms, dialkyl sulfones of the formula R¹-S(O)(O)-R² where R¹ and R² are alkyl of 1 to 4 carbon atoms, dimethyl sulfoxide (DMSO), sulfolane, methyl sulfolane, alkyl sulfolanes, dimethylacetamide and dimethylformamide.;
b) at least one nucleophilic alkanolamine,
c) at least one non-nitrogen containing weak acid in an amount sufficient to neutralize from about 3% to about 75%, preferably from about 19 % to about 75%, by weight of the nucleophilic alkanolamine such that the stripping composition has an aqueous pH of from about 9.6 to about 10.9, said weak acid having a pK value in aqueous solution of 2.0 or greater and an equivalent weight of less than 140,
d) at least one metal-removing compound selected from the group consisting of diethylene glycol and diethylene glycolamine,
e) water, and
optionally one or more components selected from the group consisting of metal-complexing/corrosion resisting compounds, other corrosion inhibitors and surfactants.

The method for cleaning microelectronic substrates according to this invention comprises a method for cleaning microelectronic substrates without producing any substantial metal corrosion, the substrate containing at least one photoresist polymeric material, etch residues and metal residues, the process comprising contacting the substrate with a cleaning composition for a time sufficient to clean the substrate, wherein the cleaning composition consists of:
a) at least one organic stripping solvent comprising a solvent selected from the group consisting of 2-pyrrolidinone, 1-methyl-2-pyrrolidinone, 1-ethyl-2-pyrrolidinone, 1-propyl-2-pyrrolidinone, 1-hydroxyethyl-2-pyrrolidinone, 1-hydroxypropyl-2-pyrrolidinone, diethylene glycol monoalkyl ethers of the formula HO-CH₂-O-CH₂-CH₂-O-R where R is an alkyl radical of from 1 to 4 carbon atoms, dialkyl sulfones of the formula R¹-S(O)(O)-R² where R¹ and R² are alkyl of 1 to 4 carbon atoms, dimethyl sulfoxide (DMSO), sulfolane, methyl sulfolane, alkyl sulfolanes, dimethylacetamide and dimethylformamide.;
b) at least one nucleophilic alkanolamine,
c) at least one non-nitrogen containing weak acid in an amount sufficient to neutralize from about 3% to about 75%, preferably from about 19% to about 75%, by weight of the nucleophilic alkanolamine such that the stripping composition has an aqueous pH of from about 9.6 to about 10.9, said weak acid having a pK value in aqueous solution of 2.0 or greater and an equivalent weight of less than 140,
d) at least one metal-removing compound selected from the group consisting of diethylene glycol and diethylene glycolamine,
e) water, and
optionally one or more components selected from the group consisting of metal-complexing/corrosion resisting compounds, other corrosion inhibitors and surfactants. The method of cleaning microelectronic substrates in accordance with this invention is particularly useful for cleaning substrate that comprises an aluminum metallized substrate having vias and containing metal residue from at least one of layers of titanium and/or titanium nitride.

### DETAILED DESCRIPTION OF THE INVENTION AND PREFRRED EMBODIMENTS.

This invention provides stripping and cleaning compositions for cleaning microelectronics substrates, the composition comprising: at least one organic stripping solvent, at least one nucleophilic alkanolamine, at least one non-nitrogen containing weak acid in an amount sufficient to neutralize from about 3% to about 75%, preferably from about 19% to about 75%, by weight of the nucleophilic alkanolamine such that the stripping composition has an aqueous pH of from about 9.6 to about 10.9, said weak acid having a pK value in aqueous solution of 2.0 or greater and an equivalent weight of less than 140, at least one metal-removing compound selected from the group consisting of diethylene glycol and diethylene glycolamine, and water, and methods for cleaning microelectronic substrates with these compositions.

The stripping and cleaning composition of this invention for cleaning microelectronics substrates consists of:
a) at least one organic stripping solvent comprising a solvent selected from the group consisting of 2-pyrrolidinone, 1-methyl-2-pyrrolidinone, 1-ethyl-2-pyrrolidinone, 1-propyl-2-pyrrolidinone, 1-hydroxyethyl-2-pyrrolidinone, 1-hydroxypropyl-2-pyrrolidinone, diethylene glycol monoalkyl ethers of the formula HO-CH₂-O-CH₂-CH₂-O-R where R is an alkyl radical of from 1 to 4 carbon atoms, dialkyl sulfones of the formula R¹-S(O)(O)-R² where R¹ and R² are alkyl of 1 to 4 carbon atoms, dimethyl sulfoxide (DMSO), sulfolane, methyl sulfolane, alkyl sulfolanes, dimethylacetamide and dimethylformamide.;
b) at least one nucleophilic alkanolamine,
c) at least one non-nitrogen containing weak acid in an amount sufficient to neutralize from about 3% to about 75%, preferably from about 19% to about 75%, by weight of the nucleophilic alkanolamine such that the stripping composition has an aqueous pH of from about 9.6 to about 10.9, said weak acid having a pK value in aqueous solution of 2.0 or greater and an equivalent weight of less than 140,
d) at least one metal-removing compound selected from the group consisting of diethylene glycol and diethylene glycolamine,
e) water, and
optionally one or more components selected from the group consisting of metal-complexing/corrosion resisting compounds, other corrosion inhibitors arid surfactants.

The at least one organic stripping solvent will generally be present in the composition in an amount of from about 20 to about 80 wt%, preferably in an amount of from about 30 to about 75 wt%, and more preferably in an amount of from about 40 to about 60 wt%. Preferably the solvent is N-methyl pyrrolidone.

The at least one nucleophilic alkanolamine components of the compositions of this invention will generally be present in the compositions in an amount of from about 1 to about 50 wt%, preferably from about 10 to about 45 wt%, and more preferably from about 20 to about 30 wt%. Among the alkanolamine components that may be used there may be mentioned, monoethanolamine, 1-amino-2-propanol, 2-(2-aminoethoxy)ethanol, 2-aminoethanol and 2-(2-aminoethylamino)ethanol. More important than the actual pK value of an alkanolamine is its its nucleophilicity which should be high. Most preferably the nucleophilic alkanolamine is monoethanolamine or 1-amino-2-propoanol.

The non-nitrogen-containing weak acids component of the compositions of this invention will generally be present in the composition in an amount of from about 0.5 to about 10 wt%, preferably from about 1 to about 8 wt%, and more preferably from about 2 to about 6 wt%. The non-nitrogen containing weak acids that may be employed in this invention include organics such as carboxylic acids or phenols as well as salts of inorganic acids such as carbonic or hydrofluoric acid. By weak acids is meant acids having a strength expressed as a "pK" for the dissociation constant in aqueous solution of at least 2.0 or higher, preferably 2.5 or higher. Particularly useful are weak acids of pK>2.0 and preferably having an equivalent weight of less than about 140. As examples of such non-nitrogen containing weak acids useful in this invention there may be mentioned, for example, carboxylic acids such as acetic acid, phthalic acid, phenoxyacetic acid and the like, organic acids such as 2-mercaptobenzoic acid, 2-mercaptoethanol and the like, phenols generally having pK in the range of from 9 to 10, such as phenol, catechol, 1,3,5-trihydroxybenzene, pyrogallol, resorcinol, 4-tert-butylcatechol and the like, and inorganic acids such as carbonic acid, hydrofluoric acid and the like. The amount of weak acid employed in the stripping compositions of this invention is an amount to neutralize from about 3% to about 75%, preferably from about 19% to about 75%, by weight of the alkanolamine present in the stripper composition thereby resulting in an aqueous rinse pH for said stripper compositions of from about pH 9.6 to about 10.9. Most preferably the weak acid is catechol.

The at least one metal-removing component is diethylene glycol or diethylene glycolamine or mixtures thereof. This component is generally present in the composition in an amount of from about 0.5 to about 40 wt%, preferably from about 1 to about 20 wt%, and more preferably from about 5 to about 15 wt%. This component is preferably diethylene glycol.

The cleaning and stripping compositions of this invention are alkaline aqueous compositions and water is present generally in an amount of from about 0.5 to about 50 wt%, preferably from about 1 to about 35 wt%, and more preferably from about 5 to about 20 wt%.

The compositions of this invention may also optionally contain one ore more components selected from the group consisting of metal-complexing/corrosion resisting compounds, other corrosion inhibitors and surfactants.

Organic or inorganic chelating or metal complexing agents/corrosion inhibitors are not required, but may optionally be included in the compositions of this invention, but offer substantial benefits, such as for example, improved product stability when incorporated into the aqueous cleaning compositions of this invention. Examples of suitable chelating or complexing agents include but are not limited to trans-1,2-cyclohexanediamine tetraacetic acid (CyDTA), ethylenediamine tetraacetic acid (EDTA), stannates, pyrophosphates, alkylidene-diphosphonic acid derivatives (e.g. ethane-1-hydroxy-1,1-diphosphonate), phosphonates containing ethylenediamine, diethylenetriamine or triethylenetetramine functional moieties [e,g. ethylenediamine tetra(methylene phosphonic acid) (EDTMP), diethylenetriamine penta(methylene phosphonic acid), triethylenetetramine hexa(methylene phosphonic acid). The chelating agent will be present in the composition in an amount of from 0 to about 5 wt%, preferably from about 0.1 to about 2 wt% based on the weight of the composition.

The aqueous cleaning compositions of this invention can also optionally contain other corrosion inhibitors and similar non-corrosive components employed in microelectronic cleaner compositions. The compounds may include resorcinol, gallic acid, propyl gallate, pyrogallol, hydroquinone, benzotriazole and derivatives of benzotriazole, and polyfunctional carboxylic acids such as citric acid, tartaric acid, gluconic acid, saccharic acid, glyceric acid, oxalic acid, phthalic acid, maleic acid, mandelic acid, malonic acid, lactic acid, and salicylic acid. These other corrosion inhibitors may be present in any suitable amount, generally in an amount of from about 0 to about 5 wt%, preferably from about 0.1 to about 3 wt%, and more preferably from about 0.2 to about 2 wt%.

The compositions of the present invention may also optionally contain any suitable water-soluble amphoteric, non-ionic, cationic or anionic surfactant. The addition of a surfactant will reduce the surface tension of the formulation and improve the wetting of the surface to be cleaned and therefore improve the cleaning action of the composition. The surfactant may also be added to reduce aluminum corrosion rates if further aluminum corrosion inhibition is desired. Amphoteric surfactants useful in the compositions of the present invention include betaines and sulfobetaines such as alkyl betaines, amidoalkyl betaines, alkyl sulfobetaines and amidoalkyl sulfobetaines; aminocarboxylic acid derivatives such as amphoglycinates, amphopropionates, amphodiglycinates, and amphodipropionates; iminodiacids such as alkoxyalkyl iminodiacids or alkoxyalkyl iminodiacids; amine oxides such as alkyl amine oxides and alkylamido alkylamine oxides; fluoroalkyl sulfonates and fluorinated alkyl amphoterics; and mixtures thereof. Preferably, the amphoteric surfactants are cocoamidopropyl betaine, cocoamidopropyl dimethyl betaine, cocoamidopropyl hydroxy sultaine, capryloamphodipropionate, cocoamidodipropionate, cocoamphopropionate, cocoamphohydroxyethyl propionate, isodecyloxypropylimino dipropionic acid, laurylimino dipropionate, cocoamidopropylamine oxide and cocoamine oxide and fluorinated alkyl amphoterics. Non-ionic surfactants useful in the compositions of the present invention include acetylenic diols, ethoxylated acetylenic diols, fluorinated alkyl alkoxylates, fluorinated alkylesters, fluorinated polyoxyethylene alkanols, aliphatic acid esters of polyhydric alcohols, polyoxyethylene monoalkyl ethers, polyoxyethylene diols, siloxane type surfactants, and alkylene glycol monoalkyl ethers. Preferably, the non-ionic surfactants are acetylenic diols or ethoxylated acetylenic diols. Anionic surfactants useful in the compositions of the present invention include carboxylates, N-acylsarcosinates, sulfonates, sulfates, and mono and diesters of orthophosphoric acid such as decyl phosphate. Preferably, the anionic surfactants are metal-free surfactants. Cationic surfactants useful in the compositions of the present invention include amine ethoxylates, dialkyldimethylammonium salts, dialkylmorpholinum salts, alkylbenzyldimethylammonium salts, alkyltrimethylammonium salts, and alkylpyridinium salts. Preferably, the cationic surfactants are halogen-free surfactants. Example of especially suitable surfactants include, but are not limited to 3,5-dimethyl-1-hexyn-3-ol (Surfynol-61), ethoxylated 2,4,7,9-tetramethyl-5-decyne-4,7-diol (Surfynol-465), polytetrafluoroethylene cetoxypropylbetaine (Zonyl FSK), Zonyl FSH, Triton X-100, namely octylphenoxypolyethoxyethanol, and the like. The surfactant will generally be present in an amount of from 0 to about 5 wt%, preferably 0.001 to about 3 wt% based on the weight of the composition.

Example of cleaning compositions of this invention include, but are not limited to, the compositions set forth in the following Tables 1, 2, 3 and 4. In Tables 1, 2, 3 and 4, as well as in following Tables 5 through 9, the abbreviations employed are as follows:
- NMP=: N-methyl pyrrolidinone
- DMSO=: dimethyl sulfoxide
- DMAC=: dimethyacetamide
- DMF=: dimethformamide
- DEG=: diethylene glycol
- DEGA=: diethylene glycolamine
- CAT=: catechol
- MEA=: monoethanolamine
- AMP=: 1-amino-2-propanol

**Table 1**

| Compositions/Parts by Weight | | | | | |
|---|---|---|---|---|---|
| **Components** | **1** | **2** | **3** | **4** | **5** |
| NMP | 46 | 26 | 26 | 26 | 26 |
| DMSO | | | | | |
| DMAC | | | | | |
| MEA | 23 | 20 | 20 | 10 | 10 |
| AMP | | | | | |
| DEG | 11 | 8 | | | |
| DEGA | | | 8 | 2 | 8 |
| CAT | 5 | 1 | 1 | 1 | 5 |
| WATER | 15 | 4 | 4 | 4 | 4 |

**Table 2**

| Compositions/Parts by Weight | | | | | |
|---|---|---|---|---|---|
| **Components** | **6** | **7** | **8** | **9** | **10** |
| NMP | 26 | 26 | 26 | 26 | 26 |
| DMSO | | | | | |
| DMAC | | | | | |
| MEA | 20 | 20 | 15 | 15 | 15 |
| AMP | | | | | |
| DEG | | | | | 5 |
| DEGA | 2 | 8 | 5 | 5 | |
| CAT | 5 | 5 | 3 | 1 | 3 |
| WATER | 4 | 10 | 7 | 7 | 4 |

**Table 3**

| Compositions/Parts by Weight | | | | | |
|---|---|---|---|---|---|
| **Components** | **11** | **12** | **13** | **14** | **15** |
| NMP | 46 | 46 | 54 | 46 | |
| DMSO | | | | | |
| DMAC | | | | | 46 |
| MEA | 21 | 25 | 21 | | |
| AMP | | | | 23 | 23 |
| DEG | 13 | 9 | | 11 | 11 |
| DEGA | | | 9 | | |
| CAT | 7 | 3 | 3 | 5 | 5 |
| WATER | 13 | 17 | 13 | 15 | 15 |

**Table 4**

| Compositions/Parts by Weight | |
|---|---|
| **Components** | **16** |
| NMP | |
| DMSO | 46 |
| DMAC | |
| MEA | 23 |
| AMP | |
| DEG | 11 |
| DEGA | |
| CAT | 5 |
| WATER | 15 |

The outstanding performance cleaning and non-corrosive properties of the cleaning compositions of this invention compared to similar compositions with other polyhyroxyl compounds instead of DEG and DEGA is demonstrated by the following cleaning Examples 1 to 11. Several cleaning compositions were prepared by mixing 26 g of NMP, 20 g of monoethanolamine, 1 g of catechol, 4 g of DI water, and 8 g of a cleaning compound from the following: diethylene glycol (DEG), diethylene glycolamine (DEGA), triethylene glycol, tetraethylene glycol, ethylene glycol propylene glycol, N-methylethanolamine, 2-(2-aminoethylamino)ethanol, 2-butene-1,4-diol and 2-(2-methoxyethoxy)ethanol. Patterned Al technology wafer samples with "punch-through" via structures (vias etch through Si and TiN to an Al layer) were placed in these solutions of heated to 85° C for 20 minutes after which they were removed, rinsed in DI water for two minutes and blown dry with nitrogen. For comparison, the same wafers were cleaned in a commercially available stripping composition of US Patent 5,308,745 (containing NMP, sulfolane, MEA, catechol and DI water). The cleaned wafers were then evaluated for ash residue removal (0 = no removal to 10 = 100% removal) and aluminum corrosion (0 =no corrosion to 10 =corrosion), as noted below in Table 5

**Table 5**

| Example # | Cleaning compound | Aluminum corrosion | Ash residue removal |
|---|---|---|---|
| 1 | diethylene glycol | 0 | 10 |
| 2 | diethylene glycolamine | 1 | 8 |
| 3 | tetraethylene glycol | 0 | 5 |
| 4 | 2-butene-1,4-diol | 0 | 5 |
| 5 | ethylene glycol | 0 | 4 |
| 6 | propylene glycol | 0 | 4 |
| 7 | N,N-dimethylethanolamine | 1 | 4 |
| 8 | 2-(2-aminoethylamino)ethanol | 2 | 2 |
| 9 | 2-(2-methoxyethoxy)ethanol | 0 | 2 |
| 10 | triethylene glycol | 0 | 1 |
| 11 | Commercial product of US Patent 5, 308,745 | 0 | 1 |

Only DEG and DEGA provide both excellent ash residue removal and aluminum corrosion inhibition. The usefulness of the cleaning compositions of this invention under a variety of cleaning conditions of time and temperature and with varying formulations is exemplified in the following Examples 12 to 29.

### Examples 12 to 16

Several cleaning compositions were prepared by mixing 1-methyl-2-pyrrolidinone (NMP), monoethanolamine (MEA), diethylene glycolamine (DEGA), catechol (CAT), and DI water in the amounts shown below. The same type of patterned Al technology wafer samples with "punch-through" vias as employed in Examples 1 to 11 were placed in these solutions of heated to 85° C for 20 minutes after which they were removed, rinsed in DI water for two minutes and blown dry with nitrogen. The cleaned wafers were then evaluated for ash residue removal (0 = no removal to 10 = 100% removal) and aluminum corrosion (0 =no corrosion to 10 = severe corrosion), as noted in Table 6.

**Table 6**

| Example # | NMP | MEA | DEGA | Catechol | H₂O | Aluminum corrosion | Ash residue removal |
|---|---|---|---|---|---|---|---|
| 12 | 26 | 10 | 2 | 1 | 4 | 0 | 10 |
| 13 | 26 | 10 | 8 | 5 | 4 | 0 | 8 |
| 14 | 26 | 20 | 2 | 5 | 4 | 0 | 10 |
| 15 | 26 | 20 | 8 | 5 | 10 | 2 | 10 |
| 16 | 26 | 15 | 5 | 3 | 7 | 1 | 10 |

### Examples 17 to 22

Several cleaning compositions were prepared by mixing 26 g of NMP, 15 g monoethanolamine (MEA), 5 g of either diethylene glycoamine (DEGA) or diethylene glycol (DEG), 3 g of catechol (CAT), and 7 g of DI water. The same type of patterned Al technology wafer samples with "punch-through" vias as employed in the previous Examples were placed in these solutions of heated to the temperatures indicated below for 20 minutes after which they were removed, rinsed in DI water for two minutes and blown dry with nitrogen. The cleaned wafers were then evaluated for ash residue removal (0 = no removal to 10 = 100% removal) and aluminum corrosion (0 =no corrosion to 10 = severe corrosion), as noted below in Table 7.

**Table 7**

| Example # | Solution containing: | Temperature (°C) | Aluminum corrosion | Ash residue removal |
|---|---|---|---|---|
| 17 | DEGA | 65 | 0 | 3 |
| 18 | DEGA | 75 | 0 | 6 |
| 19 | DEGA | 85 | 1 | 9 |
| 20 | DEG | 65 | 0 | 6 |
| 21 | DEG | 75 | 0 | 8 |
| 22 | DEG | 85 | 0 | 10 |

### Examples 23 to 25

Several cleaning compositions were prepared by mixing 1-methyl-2-pyrrolidinone (NMP), monoethanolamine (MEA), diethylene glycol (DEG), catechol (CAT), and DI water in the amounts shown below. The same type of patterned Al technology wafer samples with "punch-through" vias as employed in the previous Examples were placed in these solutions of heated to 65° C for 20 minutes after which they were removed, rinsed in DI water for two minutes and blown dry with nitrogen. The cleaned wafers were then evaluated for ash residue removal (0 = no removal to 10 = 100% removal) and aluminum corrosion (0 =no corrosion to 10 = severe corrosion), as noted below in Table 8.

**Table 8**

| Example # | NMP | MEA | DEG | Catechol | H₂O | Aluminum corrosion | Ash residue removal |
|---|---|---|---|---|---|---|---|
| 23 | 46 | 21 | 13 | 7 | 13 | 0 | 10 |
| 24 | 46 | 25 | 9 | 7 | 13 | 2 | 10 |
| 25 | 54 | 21 | 9 | 3 | 13 | 1 | 10 |

### Examples 26-29

Several cleaning compositions were prepared by mixing 46 g of a solvent selected from the following: 1-methyl-2-pyrrolidinone (NMP), N,N-dimethylacetamide (DMAC), or dimethylsulfoxide (DMSO), 23 g of monoethanolamine (MEA) or 1-amino-2-propanol (AMP); 11 g of diethylene glycol (DEG), 5 g of catechol (CAT), and 15 g of DI water. The same type of patterned Al technology wafer samples with "punch-through" vias as employed in the previous Examples were placed in these solutions of heated to 65° C for 20 minutes after which they were removed, rinsed in DI water for two minutes and blown dry with nitrogen. The cleaned wafers were then evaluated for ash residue removal (0 = no removal to 10 = 100% removal) and aluminum corrosion (0 =no corrosion to 10 = severe corrosion), as noted below in Table 9.

**Table 9**

| Example # | | | | | | Aluminum corrosion | Ash residue removal |
|---|---|---|---|---|---|---|---|
| 26 | NMP | MEA | DEG | catechol | H₂O | 0 | 10 |
| 27 | NMP | AMP | DEG | catechol | H₂O | 0 | 8 |
| 28 | DMAC | MEA | DEG | catechol | H₂O | 2 | 10 |
| 29 | DMSO | MEA | DEG | catechol | H₂O | 1 | 9 |

## Claims

1. A stripping and cleaning composition for cleaning microelectronics substrates, the composition consisting of:
a) at least one organic stripping solvent comprising a solvent selected from the group consisting of 2-pyrrolidinone, 1-methyl-2-pyrrolidinone, 1-ethyl-2-pyrrolidinone, 1-propyl-2-pyrrolidinone, 1-hydroxyethyl-2-pyrrolidinone, 1-hydroxypropyl-2-pyrrolidinone, diethylene glycol monoalkyl ethers of the formula HO-CH₂-O-CH₂-CH₂-O-R where R is an alkyl radical of from 1 to 4 carbon atoms, dialkyl sulfones of the formula R¹-S(O)(O)-R² where R¹ and R² are alkyl of 1 to 4 carbon atoms, dimethyl sulfoxide (DMSO), sulfolane, methyl sulfolane, alkyl sulfolanes, dimethylacetamide and dimethylformamide;
b) at least one nucleophilic alkanolamine;
c) at least one non-nitrogen containing weak acid in an amount sufficient to neutralize from about 3% to about 75% by weight of the nucleophilic alkanolamine such that the stripping composition has an aqueous pH of from about 9.6 to about 10.9. said weak acid having a pK value in aqueous solution of 2:0 or greater and an equivalent weight of less than 140,
d) at least one metal-removing compound selected from the group consisting of diethylene glycol and diethylene glycolamine,
e) water, and
optionally one or more components selected from the group consisting of: metal-complexing/corrosion resisting compounds, other corrosion inhibitors and surfactants.

2. A composition according to claim 1 wherein the at least one organic stripping solvent comprises a solvent selected from the group consisting of N-methyl pyrrolidone, dimethylacetamide, and dimethyl sulfoxide.

3. A composition according to claim 1 wherein the alkanolamine is selected from the group consisting of monoethanolamine and 1-amino-2-propanol.

4. A composition according to claim 3 the at least one weak acid comprises catechol.

5. A composition according to claim 4 wherein the at least one organic stripping solvent comprises N-methyl pyrrolidone, the alkanolamine comprises monoethanolamine and the at least one metal-removing compound comprises diethylene glycol.

6. A composition according to claim 1 additionally comprising one or more components selected from the group consisting of: metal-complexing/corrosion resisting compounds, other corrosion inhibitors and surfactants,

7. A composition according to claim 5 additionally comprising one or more components selected from the group consisting of: metal-complexing/corrosion resisting compounds, other corrosion inhibitors and surfactants.

8. A composition according to claim 1 comprising from about 20 to about 80 wt% of the at least one stripping solvent, from about 1 to about 50 wt% of the at least one nucleophilic alkanolamine, from about 0.5 to about 40 wt% of the at least one metal-removing compound, from about 0.5 to about 10 wt% of the at least one weak acid, and from about 0.5 to about 50 wt% of water.

9. A composition according to claim 5 comprising from about 20 to about 80 wt% of N-methyl pyrrolidone, from about 1 to about 50 wt% of monoethanolamine, from about 0.5 to about 40 wt% of diethyleneglycol, from about 0.5 to about 10 wt% of catechol, and from about 0.5 to about 50 wt% of water.

10. A composition according to claim 1 comprising from about 40 to about 60 wt% of the at least one organic stripping solvent, from about 20 to about 30 wt% of the at least one nucleophilic alkanolamine, from about 5 to about 15 wt% of the at least one metal-removing compound, from about 2 to about 6 wt% of the at least one weak acid, and from about 5 to about 20 wt% of water.

11. A composition according to claim 5 comprising from about 40 to about 60 wt% of N-methyl pyrrolidone, from about 20 to about 30 wt% of monoethanolamine, from about 5 to about 15 wt% of diethyleneglycol, from about 2 to about 6 wt% of catechol, and from about 5 to about 20 wt% of water.

12. A composition according to claim 11 comprising about 46 wt% of N-methyl pyrrolidone, about 23 wt% of monoethanolamine, about 11 wt% of diethyleneglycol, about 5 wt% of catechol, and about 15 wt% of water.

13. A method for cleaning microelectronic substrates without producing any substantial metal corrosion, the substrate containing at least one of photoresist polymeric material, etch residues and metal residues, the process comprising contacting the substrate with a cleaning composition for a time sufficient to clean the substrate, wherein the cleaning composition consists of:
a) at least one organic stripping solvent comprising a solvent selected from the group consisting of 2-pyrrolidinone, 1-methyl-2-pyrrolidinone, 1-ethyl-2-pyrrolidinone, 1-propyl-2-pyrrolidinone, 1-hydroxyethyl-2-pyrrolidinone, 1-hydroxypropyl-2-pyrrolidinone, diethylene glycol monoalkyl ethers of the formula HO-CH₂-O-CH₂-CH₂-O-R where R is an alkyl radical of from 1 to 4 carbon atoms, dialkyl sulfones of the formula R¹-S(O)(O)-R² where R¹ and R² are alkyl of 1 to 4 carbon atoms, dimethyl sulfoxide (DMSO), sulfolane, methyl sulfolane, alkyl sulfolanes, dimethylacetamide and dimethylformamide;
b) at least one nucleophilic alkanolamine,
c) at least one non-nitrogen containing weak acid in an amount sufficient to neutralize from about 3% to about 75% by weight of the nucleophilic alkanolamine such that the stripping composition has an aqueous pH of from about 9.6 to about 10.9, said weak acid having a pK value in aqueous solution of 2.0 or greater and an equivalent weight of less than 140,
d) at least one metal-removing compound selected from the group consisting of diethylene glycol and diethylene glycolamine,
e) water, and
optionally one or more components selected from the group consisting of:
metal-complexing/corrosion resisting compounds, other corrosion inhibitors and surfactants.

14. A method according to claim 13 wherein the at least one organic stripping solvent comprises a solvent selected from the group consisting of N-methyl pyrrolidone, dimethylacetamide, and dimethyl sulfoxide.

15. A method according to claim 13 wherein the alkanolamine is selected from the group consisting of monoethanolamine and 1-amino-2-propanol.

16. A method according to claim 15 the at least one weak acid comprises catechol.

17. A method according to claim 16 wherein the at least one organic stripping solvent comprises N-methyl pyrrolidone, the alkanolamine comprises monoethanolamine and the at least one metal-removing compound comprises diethylene glycol.

18. A method according to claim 13 additionally comprising one or more components selected from the group consisting of: metal-complexing/corrosion resisting compounds, other corrosion inhibitors, and surfactants.

19. A method according to claim 17 additionally comprising one or more components selected from the group consisting of: metal-complexing/corrosion resisting compounds, other corrosion inhibitors and surfactants.

20. A method according to claim 13 comprising from about 20 to about 80 wt% of the at least one organic stripping solvent, from about 1 to about 50 wt% of the at least one nucleophilic alkanolamine, from about 0.5 to about 40 wt% of the at least one metal-removing compound, from about 0.5 to about 10 wt% of the at least one weak acid, and from about 0.5 to about 50 wt% of water.

21. A method according to claim 17 comprising from about 20 to about 80 wt% of N-methyl pyrrolidone, from about 1 to about 50 wt% of monoethanolamine, from about 0.5 to about 40 wt% of diethyleneglycol, from about 0.5 to about 10 wt% of catechol, and from about 0.5 to about 50 wt% of water.

22. A method according to claim 13 comprising from about 40 to about 60 wt% of the at least one organic stripping solvent, from about 20 to about 30 wt% of the at least one nucleophilic alkanolamine, about 5 to about 15 wt% of the at least one metal-removing compound, from about 2 to about 6 wt% of the at least one weak acid, and from about 5 to about 20 wt% of water.

23. A method according to claim 17 comprising from about 40 to about 60 wt% of N-methyl pyrrolidone, from about 20 to about 30 wt% of monoethanolamine, from about 5 to about 15 wt% of diethyleneglycol, from about 2 to about 6 wt% of catechol, and from about 5 to about 20 wt% of water.

24. A method according to claim 23 comprising about 46 wt% of N-methyl pyrrolidone, about 23 wt% of monoethanolamine, about 11 wt% of diethyleneglycol, about 5 wt% of catechol, and about 15 wt% of water.

25. A method according to claim 13 wherein the substrate comprises an aluminum metallized substrate having vias and containing metal residue.

26. A method according to claim 25 wherein the metal residue is from at least one layer selected from the group consisting of titanium and titanium nitride layers.

27. A method according to claim 17 wherein the substrate comprises an aluminum metallized substrate having vias and containing metal residue.

28. A method according to claim 27 wherein the metal residue is from at least one layer selected the group consisting of titanium and titanium nitride layers.

## Patentansprüche

1. Stripping- und Reinigungszusammensetzung zum Reinigen von Mikroelektroniksubstraten, wobei die Zusammensetzung aus Folgendem besteht:
a) mindestens einem organischen Stripping-Lösungsmittel, umfassend ein Lösungsmittel, das aus der Gruppe ausgewählt ist, die aus 2-Pyrrolidinon, 1-Methyl-2-Pyrrolidinon, 1-Ethyl-2-Pyrrolidinon, 1-Propyl-2-Pyrrolidinon, 1-Hydroxyethyl-2-Pyrrolidinon, 1-Hydroxypropyl-2-Pyrrolidinon, Diethylenglykolmonoalkylether der Formel HO-CH₂-O-CH₂-CH₂-O-R, wobei R ein Alkyl-Radikal aus 1 bis 4 Kohlenstoffatomen ist, Dialkylsulfone der Formel R¹-S(O)(O)-R², wobei R¹ und R² Alkyle von 1 bis 4 Kohlenstoffatomen sind, Dimethylsulfoxid (DMSO), Sulfolan, Methylsulfolan, Alkylsulfolanen, Dimethylacetamid und Dimethylformamid besteht;
b) mindestens einem nucleophilen Alkanolamin,
c) mindestens einer Stickstoff nicht enthaltenden schwachen Säure in einer Menge, die zum Neutralisieren von ungefähr 3% bis ungefähr 75% Gewichtsprozent des nucleophilen Alkanolamins ausreicht, so dass die Stripping-Zusammensetzung einen wässrigen pH-Wert von ungefähr 9,6 bis ungefähr 10,9 hat, wobei die schwache Säure einen pK-Wert in wässriger Lösung von 2,0 oder größer und eine Äquivalentmasse von weniger als 140 hat,
d) mindestens einer Metall entfernenden Verbindung, die aus der Gruppe ausgewählt ist, die aus Diethylenglykol und Diethylenglykolamin besteht,
e) Wasser, und
wahlweise einem oder mehreren Bestandteilen, die aus der Gruppe ausgewählt sind, die aus metallkomplexbildenden / korrosionsbeständigen Verbindungen, anderen Korrosionsinhibitoren und oberflächenaktiven Mitteln besteht.

2. Zusammensetzung nach Anspruch 1, wobei das mindestens eine organische Stripping-Lösungsmittel ein Lösungsmittel umfasst, das aus der Gruppe ausgewählt ist, die aus N-Methyl-Pyrrolidon, Dimethylacetamid und Dimethylsulfoxid besteht.

3. Zusammensetzung nach Anspruch 1, wobei das Alkanolamin aus der Gruppe ausgewählt ist, die aus Monoethanolamin und 1-Amino-2-Propanol besteht.

4. Zusammensetzung nach Anspruch 3, wobei die mindestens eine schwache Säure Catechol umfasst.

5. Zusammensetzung nach Anspruch 4, wobei das mindestens eine organische Stripping-Lösungsmittel N-Methyl-Pyrrolidon umfasst, das Alkanolamin Monoethanolamin umfasst und die mindestens eine Metall entfernende Verbindung Diethylenglykol umfasst.

6. Zusammensetzung nach Anspruch 1, zusätzlich umfassend eines oder mehrere Bestandteile, die aus der Gruppe ausgewählt sind, die aus metallkomplexbildenden / korrosionsbeständigen Verbindungen, anderen Korrosionsinhibitoren und oberflächenaktiven Mitteln besteht.

7. Zusammensetzung nach Anspruch 5, zusätzlich umfassend eines oder mehrere Bestandteile, die aus der Gruppe ausgewählt sind, die aus metallkomplexbildenden / korrosionsbeständigen Verbindungen, anderen Korrosionsinhibitoren und oberflächenaktiven Mitteln besteht.

8. Zusammensetzung nach Anspruch 1, umfassend von ungefähr 20 bis ungefähr 80 Gewichtsprozent des mindestens einen Stripping-Lösungsmittels, von ungefähr 1 bis ungefähr 50 Gewichtsprozent des mindestens einen nucleophilen Alkanolamins, von ungefähr 0,5 bis ungefähr 40 Gewichtsprozent der mindestens einen Metall entfernenden Verbindung, von ungefähr 0,5 bis ungefähr 10 Gewichtsprozent der mindestens einen schwachen Säure und von ungefähr 0,5 bis ungefähr 50 Gewichtsprozent Wasser.

9. Zusammensetzung nach Anspruch 5, umfassend von ungefähr 20 bis ungefähr 80 Gewichtsprozent N-Methyl-Pyrrolidon, von ungefähr 1 bis ungefähr 50 Gewichtsprozent Monoethanolamin, von ungefähr 0,5 bis ungefähr 40 Gewichtsprozent Diethylenglykol, von ungefähr 0,5 bis ungefähr 10 Gewichtsprozent Catechol und von ungefähr 0,5 bis ungefähr 50 Gewichtsprozent Wasser.

10. Zusammensetzung nach Anspruch 1, umfassend von ungefähr 40 bis ungefähr 60 Gewichtsprozent des mindestens einen organischen Stripping-Lösungsmittels, von ungefähr 20 bis ungefähr 30 Gewichtsprozent des mindestens einen nucleophilen Alkanolamins, von ungefähr 5 bis ungefähr 15 Gewichtsprozent der mindestens einen Metall entfernenden Verbindung, von ungefähr 2 bis ungefähr 6 Gewichtsprozent der mindestens einen schwachen Säure und von ungefähr 5 bis ungefähr 20 Gewichtsprozent Wasser.

11. Zusammensetzung nach Anspruch 5, umfassend von ungefähr 40 bis ungefähr 60 Gewichtsprozent N-Methyl-Pyrrolidon, von ungefähr 20 bis ungefähr 30 Gewichtsprozent Monoethanolamin, von ungefähr 5 bis ungefähr 15 Gewichtsprozent Diethylenglykol, von ungefähr 2 bis ungefähr 6 Gewichtsprozent Catechol und von ungefähr 5 bis ungefähr 20 Gewichtsprozent Wasser.

12. Zusammensetzung nach Anspruch 11, umfassend ungefähr 46 Gewichtsprozent N-Methyl-Pyrrolidon, ungefähr 23 Gewichtsprozent Monoethanolamin, ungefähr 11 Gewichtsprozent Diethylenglykol, ungefähr 5 Gewichtsprozent Catechol und ungefähr 15 Gewichtsprozent Wasser.

13. Verfahren zum Reinigen von Mikroelektroniksubstraten, ohne die Hervorrufung beträchtlicher Metallkorrosion, wobei das Substrat mindestens Photolack-Polymermaterial, Ätzreste und Metallreste enthält, wobei der Prozess die folgenden Schritte umfasst: Kontaktieren des Substrats mit einer Reinigungszusammensetzung über einen Zeitraum, der zum Reinigen des Substrats ausreicht, wobei die Reinigungszusammensetzung aus Folgendem besteht:
a) mindestens einem organischen Stripping-Lösungsmittel, umfassend ein Lösungsmittel, das aus der Gruppe ausgewählt ist, die aus 2-Pyrrolidinon, 1-Methyl-2-Pyrrolidinon, 1-Ethyl-2-Pyrrolidinon, 1-Propyl-2-Pyrrolidinon, 1-Hydroxyethyl-2-Pyrrolidinon, 1-Hydroxypropyl-2-Pyrrolidinon, Diethylenglykolmonoalkylether der Formel HO-CH₂-O-CH₂-CH₂-O-R, wobei R ein Alkyl-Radikal aus 1 bis 4 Kohlenstoffatomen ist, Dialkylsulfone der Formel R¹-S(O)(O)-R², wobei R¹ und R² Alkyle von 1 bis 4 Kohlenstoffatomen sind, Dimethylsulfoxid (DMSO), Sulfolan, Methylsulfolan, Alkylsulfolanen, Dimethylacetamid und Dimethylformamid besteht;
b) mindestens einem nucleophilen Alkanolamin,
c) mindestens einer Stickstoff nicht enthaltenden schwachen Säure in einer Menge, die zum Neutralisieren von ungefähr 3% bis ungefähr 75% Gewichtsprozent des nucleophilen Alkanolamins ausreicht, so dass die Stripping-Zusammensetzung einen wässrigen pH-Wert von ungefähr 9,6 bis ungefähr 10,9 hat, wobei die schwache Säure einen pK-Wert in wässriger Lösung von 2,0 oder größer und eine Äquivalentmasse von weniger als 140 hat,
d) mindestens einer Metall entfernenden Verbindung, die aus der Gruppe ausgewählt ist, die aus Diethylenglykol und Diethylenglykolamin besteht,
e) Wasser, und
wahlweise einem oder mehreren Bestandteilen, die aus der Gruppe ausgewählt sind, die aus metallkomplexbildenden / korrosionsbeständigen Verbindungen, anderen Korrosionsinhibitoren und oberflächenaktiven Mitteln besteht.

14. Verfahren nach Anspruch 13, wobei das mindestens eine organische Stripping-Lösungsmittel ein Lösungsmittel umfasst, das aus der Gruppe ausgewählt ist, die aus N-Methyl-Pyrrolidon, Dimethylacetamid und Dimethylsulfoxid besteht.

15. Verfahren nach Anspruch 13, wobei das Alkanolamin aus der Gruppe ausgewählt ist, die aus Monoethanolamin und 1-Amino-2-Propanol besteht.

16. Verfahren nach Anspruch 15, wobei die mindestens eine schwache Säure Catechol umfasst.

17. Verfahren nach Anspruch 16, wobei das mindestens eine organische Stripping-Lösungsmittel N-Methyl-Pyrrolidon umfasst, das Alkanolamin Monoethanolamin umfasst und die mindestens eine Metall entfernende Verbindung Diethylenglykol umfasst.

18. Verfahren nach Anspruch 13, zusätzlich umfassend eines oder mehrere Bestandteile, die aus der Gruppe ausgewählt sind, die aus metallkomplexbildenden / korrosionsbeständigen Verbindungen, anderen Korrosionsinhibitoren und oberflächenaktiven Mitteln besteht.

19. Verfahren nach Anspruch 17, zusätzlich umfassend eines oder mehrere Bestandteile, die aus der Gruppe ausgewählt sind, die aus metallkomplexbildenden / korrosionsbeständigen Verbindungen, anderen Korrosionsinhibitoren und oberflächenaktiven Mitteln besteht.

20. Verfahren nach Anspruch 13, umfassend von ungefähr 20 bis ungefähr 80 Gewichtsprozent des mindestens einen organischen Stripping-Lösungsmittels, von ungefähr 1 bis ungefähr 50 Gewichtsprozent des mindestens einen nucleophilen Alkanolamins, von ungefähr 0,5 bis ungefähr 40 Gewichtsprozent der mindestens einen Metall entfernenden Verbindung, von ungefähr 0,5 bis ungefähr 10 Gewichtsprozent der mindestens einen schwachen Säure und von ungefähr 0,5 bis ungefähr 50 Gewichtsprozent Wasser.

21. Verfahren nach Anspruch 17, umfassend von ungefähr 20 bis ungefähr 80 Gewichtsprozent N-Methyl-Pyrrolidon, von ungefähr 1 bis ungefähr 50 Gewichtsprozent Monoethanolamin, von ungefähr 0,5 bis ungefähr 40 Gewichtsprozent Diethylenglykol, von ungefähr 0,5 bis ungefähr 10 Gewichtsprozent Catechol und von ungefähr 0,5 bis ungefähr 50 Gewichtsprozent Wasser.

22. Verfahren nach Anspruch 13, umfassend von ungefähr 40 bis ungefähr 60 Gewichtsprozent des mindestens einen organischen Stripping-Lösungsmittels, von ungefähr 20 bis ungefähr 30 Gewichtsprozent des mindestens einen nucleophilen Alkanolamins, von ungefähr 5 bis ungefähr 15 Gewichtsprozent der mindestens einen Metall entfernenden Verbindung, von ungefähr 2 bis ungefähr 6 Gewichtsprozent der mindestens einen schwachen Säure und von ungefähr 5 bis ungefähr 20 Gewichtsprozent Wasser.

23. Verfahren nach Anspruch 17, umfassend von ungefähr 40 bis ungefähr 60 Gewichtsprozent N-Methyl-Pyrrolidon, von ungefähr 20 bis ungefähr 30 Gewichtsprozent Monoethanolamin, von ungefähr 5 bis ungefähr 15 Gewichtsprozent Diethylenglykol, von ungefähr 2 bis ungefähr 6 Gewichtsprozent Catechol und von ungefähr 5 bis ungefähr 20 Gewichtsprozent Wasser.

24. Verfahren nach Anspruch 23, umfassend ungefähr 46 Gewichtsprozent N-Methyl-Pyrrolidon, ungefähr 23 Gewichtsprozent Monoethanolamin, ungefähr 11 Gewichtsprozent Diethylenglykol, ungefähr 5 Gewichtsprozent Catechol und ungefähr 15 Gewichtsprozent Wasser.

25. Verfahren nach Anspruch 13, wobei das Substrat ein mit Aluminium metallisiertes Substrat umfasst, das Verbindungslöcher aufweist und Metallreste enthält.

26. Verfahren nach Anspruch 25, wobei die Metallreste aus mindestens einer Schicht stammen, die aus der Gruppe ausgewählt ist, die aus Titan- und Titannitridschichten besteht.

27. Verfahren nach Anspruch 17, wobei das Substrat ein mit Aluminium metallisiertes Substrat umfasst, das Verbindungslöcher aufweist und Metallreste enthält.

28. Verfahren nach Anspruch 27, wobei die Metallreste aus mindestens einer Schicht stammen, die aus der Gruppe ausgewählt ist, die aus Titan- und Titannitridschichten besteht.

## Revendications

1. Composition d'attaque et de nettoyage pour le nettoyage de substrats microélectroniques, composition consistant en
a) au moins un solvant organique d'attaque comprenant un solvant choisi dans le groupe consistant en 2-pyrrolidinone, 1-méthyl-2-pyrrolidinone, 1-éthyl-2-pyrrolidinone, 1-propyl-2-pyrrolidinone, 1-hydroxyéthyl-2-pyrrolidinone, 1-hydroxypropyl-2-pyrrolidinone, éthers monoalkyliques de diéthylèneglycol de formule HO-CH₂-O-CH₂-CH₂-O-R où R est un radical alkyle de 1 à 4 atomes de carbone, des dialkylsulfones de formule R¹-S(O)(O)-R² où R¹ et R² sont des groupes alkyle de 1 à 4 atomes de carbone, diméthyl-sulfoxide (DMSO), sulfolane, méthyl-sulfolane, alkylsulfolanes, diméthylacétamide et diméthylformamide ;
b) au moins une alcanolamine nucléophile ;
c) au moins un acide faible non azoté en une quantité suffisante pour neutraliser environ 3 % à environ 75 % en poids de l'alcanolamine nucléophile de telle sorte que la composition d'attaque ait un pH aqueux d'environ 9,6 à environ 10,9, ledit acide faible ayant une valeur de pK en solution aqueuse égale ou supérieure à 2,0 et un poids équivalent inférieur à 140,
d) au moins un composé d'élimination de métal choisi dans le groupe consistant en le diéthylèneglycol et la diéthylèneglycolamine,
e) de l'eau, et
facultativement un ou plusieurs constituants choisis dans le groupe consistant en :
des composés complexant les métaux/inhibant la corrosion, d'autres inhibiteurs de corrosion et des agents tensioactifs.

2. Composition suivant la revendication 1, dans laquelle ledit au moins un solvant organique d'attaque comprend un solvant choisi dans le groupe consistant en la N-méthylpyrrolidone, le diméthylacétamide et le diméthylsulfoxyde.

3. Composition suivant la revendication 1, dans laquelle l'alcanolamine est choisie dans le groupe consistant en la monoéthanolamine et le 1-amino-2-propanol.

4. Composition suivant la revendication 3, dans laquelle ledit au moins un acide faible comprend du catéchol.

5. Composition suivant la revendication 4, dans laquelle ledit au moins un solvant organique d'attaque comprend de la N-méthylpyrrolidone, l'alcanolamine comprend la monoéthanolamine et ledit au moins un composé d'élimination de métal comprend le diéthylèneglycol.

6. Composition suivant la revendication 1, comprenant en outre un ou plusieurs constituants choisis dans le groupe consistant en : des composés complexant les métaux/inhibant la corrosion, d'autres inhibiteurs de corrosion et des agents tensioactifs.

7. Composition suivant la revendication 5, comprenant en outre un ou plusieurs constituants choisis dans le groupe consistant en : des composés complexant les métaux/inhibant la corrosion, d'autres inhibiteurs de corrosion et des agents tensioactifs.

8. Composition suivant la revendication 1, comprenant environ 20 à environ 80 % en poids dudit au moins un solvant d'attaque, environ 1 à environ 50 % en poids de ladite au moins une alcanolamine nucléophile, environ 0,5 à environ 40 % en poids dudit au moins un composé d'élimination de métal, environ 0,5 à environ 10 % en poids dudit au moins acide faible et environ 0,5 à environ 50 % en poids d'eau.

9. Composition suivant la revendication 5, comprenant environ 20 à environ 80 % en poids de N-méthylpyrrolidone, environ 1 à environ 50 % en poids de monoéthanolamine, environ 0,5 à environ 40 % en poids de diéthylèneglycol, environ 0,5 à environ 10 % en poids de catéchol et environ 0,5 à environ 50 % en poids d'eau.

10. Composition suivant la revendication 1, comprenant environ 40 à environ 60 % en poids dudit au moins un solvant organique d'attaque, environ 20 à environ 30 % en poids de ladite au moins une alcanolamine nucléophile, environ 5 à environ 15 % en poids dudit au moins un composé d'élimination de métal, environ 2 à environ 6 % en poids dudit au moins un acide faible et environ 5 à environ 20 % en poids d'eau.

11. Composition suivant la revendication 5, comprenant environ 40 à environ 60 % en poids de N-méthylpyrrolidone, environ 20 à environ 30 % en poids de monoéthanolamine, environ 5 à environ 15 % en poids de diéthylèneglycol, environ 2 à environ 6 % en poids de catéchol et environ 5 à environ 20 % en poids d'eau.

12. Composition suivant la revendication 11, comprenant environ 46 % en poids de N-méthylpyrrolidone, environ 23 % en poids de monoéthanolamine, environ 11 % en poids de diéthylèneglycol, environ 5 % en poids de catéchol et environ 15 % en poids d'eau.

13. Procédé pour le nettoyage de substrats microélectroniques, sans provoquer une quelconque corrosion substantielle des métaux, le substrat contenant au moins une matière polymère servant de photoresist, des résidus d'attaque et des résidus métalliques, le procédé comprenant la mise en contact du substrat avec une composition nettoyante pendant une période de temps suffisante pour nettoyer le substrat, dans lequel la composition nettoyante consistant en :
a) au moins un solvant organique d'attaque, comprenant un solvant choisi dans le groupe consistant en 2-pyrrolidinone, 1-méthyl-2-pyrrolidinone, 1-éthyl-2-pyrrolidinone, 1-propyl-2-pyrrolidinone, 1-hydroxyéthyl-2-pyrrolidinone, 1-hydroxypropyl-2-pyrrolidinone, éthers monoalkyliques de diéthylèneglycol de formule HO-CH₂-O-CH₂-CH₂-O-R où R est un radical alkyle de 1 à 4 atomes de carbone, des dialkylsulfones de formule R¹-S(O)(O)-R² où R¹ et R² sont des groupes alkyle de 1 à 4 atomes de carbone, diméthyl-sulfoxide (DMSO), sulfolane, méthyl-sulfolane, alkylsulfolanes, diméthylacétamide et diméthylformamide ;
b) au moins une alcanolamine nucléophile ;
c) au moins un acide faible non azoté en une quantité suffisante pour neutraliser environ 3 % à environ 75 % en poids de l'alcanolamine nucléophile de telle sorte que la composition d'attaque ait un pH en milieu aqueux d'environ 9,6 à environ 10,9, ledit acide faible ayant une valeur de pK en solution aqueuse égale ou supérieure à 2,0 et un poids équivalent inférieur à 140,
d) au moins un composé d'élimination de métal choisi dans le groupe consistant en le diéthylèneglycol et la diéthylèneglycolamine,
e) de l'eau, et
facultativement un ou plusieurs constituants choisis dans le groupe consistant en :
des composés complexant les métaux/inhibant la corrosion, d'autres inhibiteurs de corrosion et des agents tensioactifs.

14. Procédé suivant la revendication 13, dans lequel ledit au moins un solvant organique d'attaque comprend un solvant choisi dans le groupe consistant en la N-méthylpyrrolidone, le diméthylacétamide et le diméthylsulfoxyde.

15. Procédé suivant la revendication 13, dans lequel l'alcanolamine est choisie dans le groupe consistant en la monoéthanolamine et le 1-amino-2-propanol.

16. Procédé suivant la revendication 15, dans lequel ledit au moins un acide faible comprend le catéchol.

17. Procédé suivant la revendication 16, dans lequel ledit au moins un solvant organique d'attaque comprend la N-méthylpyrrolidone, l'alcanolamine comprend la monoéthanolamine et ledit au moins un composé d'élimination de métal comprend le diéthylèneglycol.

18. Procédé suivant la revendication 13, comprenant en outre un ou plusieurs constituants choisis dans le groupe consistant en : des composés complexant les métaux/inhibant la corrosion, d'autres inhibiteurs de corrosion et des agents tensioactifs.

19. Procédé suivant la revendication 17, comprenant en outre un ou plusieurs constituants choisis dans le groupe consistant en : des composés complexant les métaux/inhibant la corrosion, d'autres inhibiteurs de corrosion et des agents tensioactifs.

20. Procédé suivant la revendication 13, comprenant environ 20 à environ 80 % en poids dudit au moins un solvant organique d'attaque, environ 1 à environ 50 % en poids de ladite au moins une alcanolamine nucléophile, environ 0,5 à environ 40 % en poids dudit au moins un composé d'élimination de métal, environ 0,5 à environ 10 % en poids dudit au moins un acide faible et environ 0,5 à environ 50 % en poids d'eau.

21. Procédé suivant la revendication 17, comprenant environ 20 % à environ 80 % de N-méthylpyrrolidone, environ 1 à environ 50 % en poids de monoéthanolamine, environ 0,5 à environ 40 % en poids de diéthylèneglycol, environ 0,5 à environ 10 % en poids de catéchol et environ 0,5 à environ 50 % en poids d'eau.

22. Procédé suivant la revendication 13, comprenant environ 40 à environ 60 % en poids dudit au moins un solvant organique d'attaque, environ 20 à environ 30 % en poids de ladite au moins une alcanolamine nucléophile, environ 5 à environ 15 % en poids dudit au moins un composé d'élimination de métal, environ 2 à environ 6 % en poids dudit au moins un acide faible et environ 5 à environ 20 % en poids d'eau.

23. Procédé suivant la revendication 17, comprenant environ 40 à environ 60 % de N-méthylpyrrolidone, environ 20 à environ 30 % en poids de monoéthanolamine, environ 5 à environ 15 % en poids de diéthylèneglycol, environ 2 à environ 6 % en poids de catéchol et environ 5 à environ 20 % en poids d'eau.

24. Procédé suivant la revendication 23, comprenant environ 46 % en poids de N-méthylpyrrolidone, environ 23 % en poids de monoéthanolamine, environ 11 % en poids de diéthylèneglycol, environ 5 % en poids de catéchol et environ 15 % en poids d'eau.

25. Procédé suivant la revendication 13, dans lequel le substrat comprend un substrat métallisé à l'aluminium comprenant des traversées et contenant un résidu métallique.

26. Procédé suivant la revendication 25, dans lequel le résidu métallique provient d'au moins une couche choisi dans le groupe consistant en une couche de titane et une couche de nitrure de titane.

27. Procédé suivant la revendication 17, dans lequel le substrat comprend un substrat métallisé à l'aluminium comportant des traversées et contenant un résidu métallique.

28. Procédé suivant la revendication 27, dans lequel le résidu métallique provient d'au moins une couche choisie dans le groupe consistant en une couche de titane et une couche de nitrure de titane.
